# EUROPEAN PATENT SPECIFICATION

(11) **EP 3 514 449 B1**
(45) Date of publication and mention of the grant of the patent: **23.09.2020**
(21) Application number: 19152315.8
(22) Date of filing: 17.01.2019
(51) Int. Cl.: F21V 15/01, F21V 17/16, F21S 4/28, F21Y 115/10, F21Y 103/10

(54) **LIGHTING ASSEMBLY**
BELEUCHTUNGSANORDNUNG
ENSEMBLE D'ÉCLAIRAGE

(30) Priority: 22.01.2018 FI 20185054
(43) Date of publication of application: 24.07.2019
(73) Proprietor: Teknoware Oy, 15200 Lahti (FI)
(72) Inventor: Siltanen, Oskari, 15200 Lahti (FI)
(74) Representative: Papula Oy

(56) References cited:
- US-A- 6 088 967
- US-A1- 2014 268 736

## Description

### BACKGROUND OF THE INVENTION

The invention relates to a lighting assembly in which a lighting element is located inside an extruded housing.

The known lighting assembly comprises a housing and a translucent dome through which a lighting element of the lighting assembly is arranged to emit light to its surroundings. The problem in this known lighting assembly is that it is complex, which increases the manufacturing costs.

A prior art document US 6,088,967 discloses a variety of string light display boxes having box-shaped cross sections defined by profiled wall sections.

A prior art document US 2014/0268736 A1 discloses an extruded housing of a luminaire, using a single polymeric material to form an opaque body portion and a light transmitting lens portion, and a hinge portion joining these two.

### SHORT DESCRIPTION OF THE INVENTION

The object of the invention is to provide a lighting assembly which is structurally simpler than before, and less expensive to manufacture. The object of the invention is achieved by means of a lighting assembly characterized in what is put forth in the independent claim. Preferred embodiments of the invention are presented in the dependent claims.

The invention is based on the idea that the housing of the lighting assembly is manufactured in one extrusion process, so that a translucent housing wall, hinges enabling the housing to be opened and closed, and locking means which are arranged for locking the walls of the housing in their tubular operating position in which the walls of the housing surround the lighting element, are manufactured in the same extrusion process.

Advantages of the lighting assembly according to the invention are simple structure and low manufacturing costs.

### SHORT DESCRIPTION OF THE FIGURES

The invention will now be described in detail in the context of preferred embodiments, with reference to the accompanying drawings in which:
Fig. 1 shows a lighting assembly according to one embodiment of the invention;
Fig. 2 shows a cross-section of the lighting assembly of Fig. 1;
Fig. 3 shows the housing of the lighting assembly of Fig. 1 with housing walls arranged in an installation position relative to each other;
Fig. 4 shows the housing of Fig. 3 with a holder;
Fig. 5 shows a modification of the housing of Fig. 3 in which a third housing wall comprises optical prisms;
Fig. 6 shows a modification of the housing of Fig. 3 in which a third housing wall comprises a lens;
Fig. 7 shows a modification of the housing of Fig. 3 manufactured in a co-extrusion process;
Fig. 8 shows a cross-section of a lighting assembly according to an alternative non-claimed embodiment; and
Fig. 9 shows the housing of the lighting assembly of Fig. 8 with housing walls arranged in an installation position relative to each other.

### DETAILED DESCRIPTION OF THE INVENTION

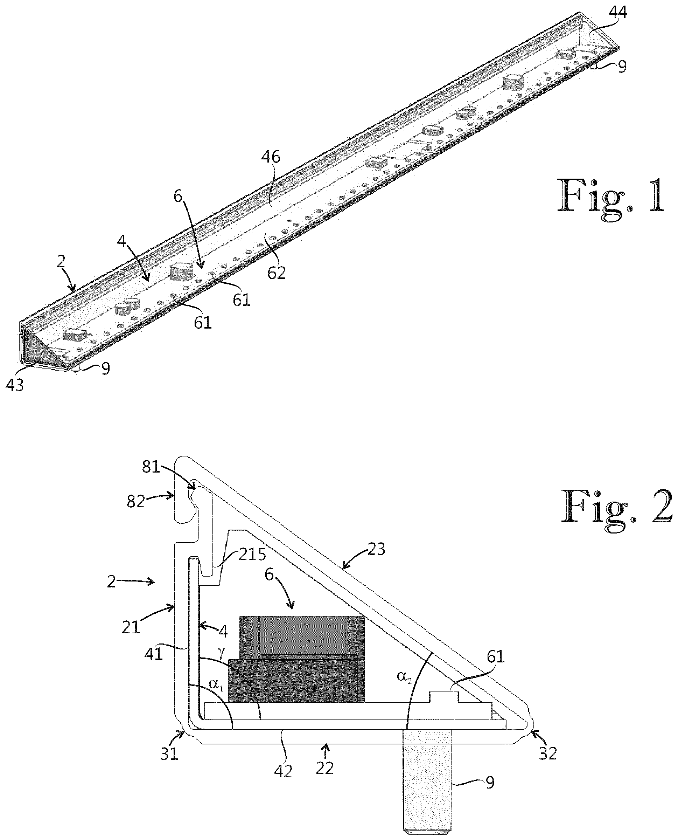

Fig. 1 shows a lighting assembly which comprises a housing 2, a holder 4 and a lighting element 6. Fig. 2 shows a cross-section of the lighting assembly of Fig. 1. The viewing direction of Fig. 2 is parallel to the longitudinal direction, i.e. the image plane in Fig. 2 is perpendicular to the longitudinal direction.

The housing 2 has been manufactured by extrusion from a flexible material, and comprises a first housing wall 21, a second housing wall 22, a third housing wall 23, a first flexible hinge 31, a second flexible hinge 32 and locking means. The material of the housing 2 is translucent. The first housing wall 21 is pivotably connected to the second housing wall 22 by means of the first flexible hinge 31, and the second housing wall 22 is pivotably connected to the third housing wall 23 by means of the second flexible hinge 32. Both of the first flexible hinge 31 and the second flexible hinge 32 extend in the longitudinal direction.

The material thickness of the first flexible hinge 31 is smaller than the material thickness of the first housing wall 21 and the second housing wall 22. The material thickness of the second flexible hinge 32 is smaller than the material thickness of the second housing wall 22 and the third housing wall 23. The hinge operation of both the first flexible hinge 31 and the second flexible hinge 32 is based solely on flexibility of the material of the housing 2.

The locking means are configured for releasably locking a free edge of the first housing wall 21 to a free edge of the third housing wall 23 to arrange the housing 2 in an operating position. A free edge of a housing wall refers herein to an edge which is not connected to an adjacent housing wall by means of a hinge. The free edge of the first housing wall 21 and the free edge of the third housing wall 23 extend parallel to the longitudinal direction.

The locking means comprise a first locking member 81 formed in the first housing wall 21, and a second locking member 82 formed in the third housing wall 23 and arranged to cooperate with the first locking member 81 for releasable locking of the free edge of the first housing wall 21 to the free edge of the third housing wall 23. The second locking member 82 comprises a locking projection which protrudes from the free edge of the third housing wall 23 at a locking projection angle θ, such that the locking projection is arranged to contact the external surface of the first housing wall 21 in the operating position of the housing 2. The locking projection angle θ indicates the extent to which the direction of the locking projection deviates inwardly from the direction of the third housing wall 23. The locking projection angle θ is approximately equal to the sum of a first operating angle and a second operating angle, i.e. 126°.

The first housing wall 21 defines a first housing wall plane, the second housing wall 22 defines a second housing wall plane, and the third housing wall 23 defines a third housing wall plane. The longitudinal direction is parallel to the first housing wall plane, the second housing wall plane and the third housing wall plane. The first housing wall 21, the second housing wall 22 and the third housing wall 23 are substantially planar walls.

The housing 2 is shown in the operating position in Fig. 1 and 2. In the operating position the first housing wall 21, the second housing wall 22 and the third housing wall 23 form a tubular structure which is open at ends, but substantially closed in a direction which is perpendicular to the longitudinal direction. The lighting element 6 is located inside said tubular structure.

In the operating position of the housing 2 a first operating angle α₁ of substantially 90° is provided between the first housing wall plane and the second housing wall plane. In alternative embodiments, in the operating position of the housing the first operating angle between the first housing wall plane and the second housing wall plane is 85° - 95°.

The third housing wall 23 is a continuous housing wall which is arranged to protect the lighting element 6 by preventing the passage of dirt from outside the housing 2 through the third housing wall 23 to contact the lighting element 6. The light from the lighting element 6 is able to propagate through the third housing wall 23 because the third housing wall 23 is made of translucent material.

In the operating position of the housing 2 a second operating angle α₂ of 36° is provided between the second housing wall plane and the third housing wall plane. In alternative embodiments, in the operating position of the housing the second operating angle between the second housing wall plane and the third housing wall plane is 25° - 60°.

The holder 4 is located inside the housing 2, and comprises a first holder wall 41, a second holder wall 42, a third holder wall 43 and a fourth holder wall 44. From Fig. 2 it is seen that in the operating position of the housing 2 the first holder wall 41 is located alongside the first housing wall 21, and the second holder wall 42 is located alongside the second housing wall 22.

The first holder wall 41 defines a first holder wall plane, and the second holder wall 42 defines a second holder wall plane. The first holder wall plane is arranged at a holder wall angle γ relative to the second holder wall plane. The holder wall angle γ is substantially 90°. In alternative embodiments the holder wall angle is 85° - 95°.

The holder 4 is an element manufactured from one aluminium sheet blank. In one alternative embodiment the holder is manufactured from other metal than aluminium. In another alternative embodiment the holder is manufactured from plastic.

The internal surface of the holder 4 comprises a light reflecting area 46. The light reflecting area 46 is part of the internal surface of the first holder wall 41. The lighting element 6 is arranged to emit light out from the housing 2 so that at least part of the light from the lighting element 6 is reflected out from the housing 2 via the light reflecting area 46 of the holder 4.

The lighting element 6 is located inside the housing 2, is fastened to the holder 4, and is arranged to emit light out from the housing 2 through the third housing wall 23. The lighting element 6 comprises several LEDs 61, and a circuit card 62 on which the several LEDs 61 are installed.

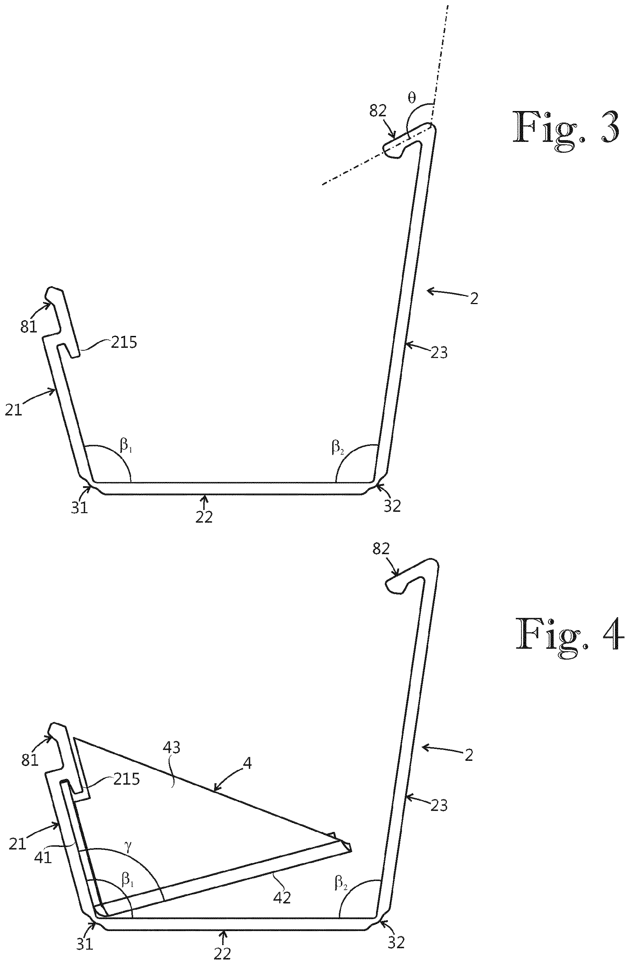

Fig. 3 shows the housing 2 separately from the other lighting assembly components. In Fig. 3 the housing walls of the housing 2 are arranged in an installation position relative to each other, i.e. the first housing wall 21 is in a first installation position relative to the second housing wall 22, and the second housing wall 22 is in a second installation position relative to the third housing wall 23. The first installation position of the first housing wall 21 and the second installation position of the second housing wall 22 are configured for installation of the holder 4 in the housing 2 and for removal of the holder 4 from the housing 2.

In the first installation position a first installation angle β₁ of 105° is provided between the first housing wall plane and the second housing wall plane. In alternative embodiments the first installation angle is at least 10° larger than the first operating angle. In the second installation position a second installation angle β₂ of 98° is provided between the second housing wall plane and the third housing wall plane. In alternative embodiments the second installation angle is at least 30° larger than the second operating angle.

The housing 2 is arranged to be such that if the angle between the first housing wall plane and the second housing wall plane is deflected from the first installation angle β₁, the angle between the first housing wall plane and the second housing wall plane will tend to return to the first installation angle β₁. Further, the housing 2 is arranged to be such that if the angle between the second housing wall plane and the third housing wall plane is deflected from the second installation angle β₂, the angle between the second housing wall plane and the third housing wall plane will tend to return to the second installation angle β₂. The housing 2 tends to return to the position according to Fig. 3, because the housing 2 has been formed by extrusion in that position.

Fig. 4 shows the housing 2 in which the housing walls are arranged in the installation position relative to each other, and which is provided with the holder 4. The housing 2 comprises a retainer projection 215 extending from the free edge of the first housing wall 21 so as to form a retaining recess between the first housing wall 21 and the retainer projection 215, the retaining recess arranged to receive a free edge of the first holder wall 41 for keeping the first holder wall 41 in place relative to the housing 2. In Fig. 4 the free edge of the first holder wall 41 has been received in said retaining recess. The retainer projection 215 is arranged to be such that when the housing walls 21, 22 and 23 are arranged in the installation position relative to each other, the holder 4 may be placed inside the housing 2 through the opening between the first housing wall 21 and the third housing wall 23, the installation direction being substantially perpendicular to the longitudinal direction.

In one alternative embodiment the angle between the first housing wall plane and the second housing wall plane does not tend to return to the first installation angle, and the angle between the second housing wall plane and the third housing wall plane does not tend to return to the second installation angle, but the first flexible hinge is arranged to allow the first housing wall to be pivoted relative to the second housing wall to the first installation position, and the second flexible hinge is arranged to allow the second housing wall to be pivoted relative to the third housing wall to the second installation position. Also in this embodiment the first installation position and the second installation position are arranged to facilitate the installation of the holder in the housing and the removal of the holder from the housing.

The third holder wall 43 is located at one end of the housing 2 as seen in the longitudinal direction, and the fourth holder wall 44 is located at the other end of the housing 2 as seen in the longitudinal direction. The third holder wall 43 and the fourth holder wall 44 are arranged to protect the lighting element 6 by preventing the passage of dirt into the housing 2 from its ends. The third holder wall 43 defines a third holder wall plane, and the fourth holder wall 44 defines a fourth holder wall plane. Both of the third holder wall plane and the fourth holder wall plane are substantially perpendicular to the longitudinal direction. In alternative embodiments the third holder wall plane and the fourth holder wall plane are arranged at an angle of over 45° to the longitudinal direction.

The lighting assembly of Fig. 1 comprises two fastening elements 9, each protruding from the second housing wall 22, and being arranged for fastening of the lighting assembly to a wall of an object to be illuminated. The fastening elements 9 are formed in the lighting element 6, i.e. they extend through both of the second holder wall 42 and the second housing wall 22.

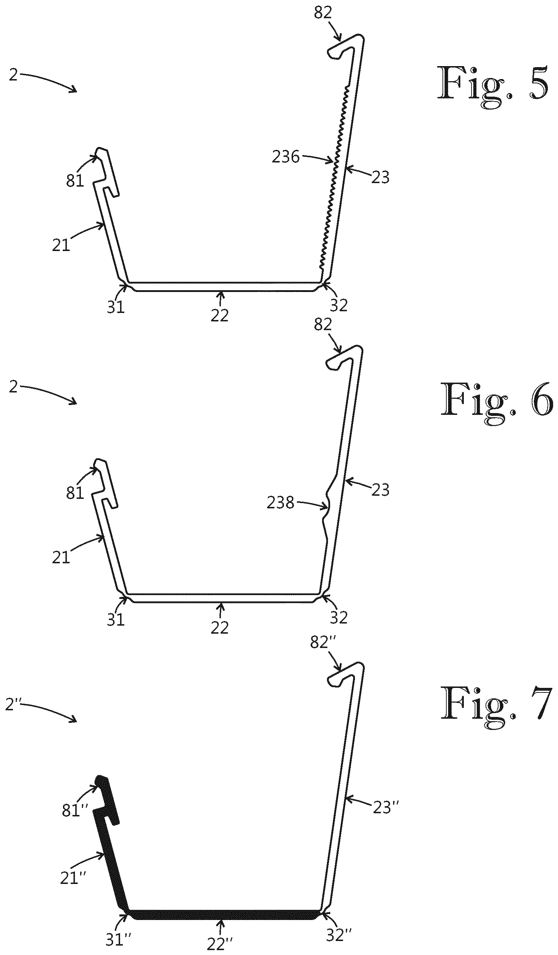

The third housing wall of the housing may be shaped so as to direct light emitted by the lighting element out from the housing in such a way that the lighting pattern from the lighting assembly will have a desired shape. Fig. 5 shows a modification of the housing of Fig. 3, in which the third housing wall 23 comprises optical prisms 236 which are arranged to direct light emitted by the lighting element out from the housing. Fig. 6 shows a modification of the housing of Fig. 3, in which the third housing wall 23 comprises a lens 238 which is arranged to direct light emitted by the lighting element out from the housing. Both of the optical prisms 236 of Fig. 5 and the lens 238 of Fig. 6 are manufactured from the same material and in the same extrusion process as the third housing wall 23. Apart from the optical prisms 236 and the lens 238, the housings of Fig. 5 and 6 are similar to the housing 2 of Fig. 3.

The housing 2 of Fig. 3 is manufactured in one extrusion process from plastic material. All parts of the housing 2 are the same material. In alternative embodiments of the invention the housing is manufactured in a co-extrusion process, such that the housing comprises two or more materials. Fig. 7 shows a modification of the housing of Fig. 3, which has been manufactured from two different materials in one co-extrusion process, such that the material of the third housing wall 23" is translucent, and the material of the first housing wall 21'' and the second housing wall 22'' is opaque. Both of the materials of the housing 2'' are flexible materials. Apart from the materials, the housing 2'' of Fig. 7 is similar to the housing 2 of Fig. 3.

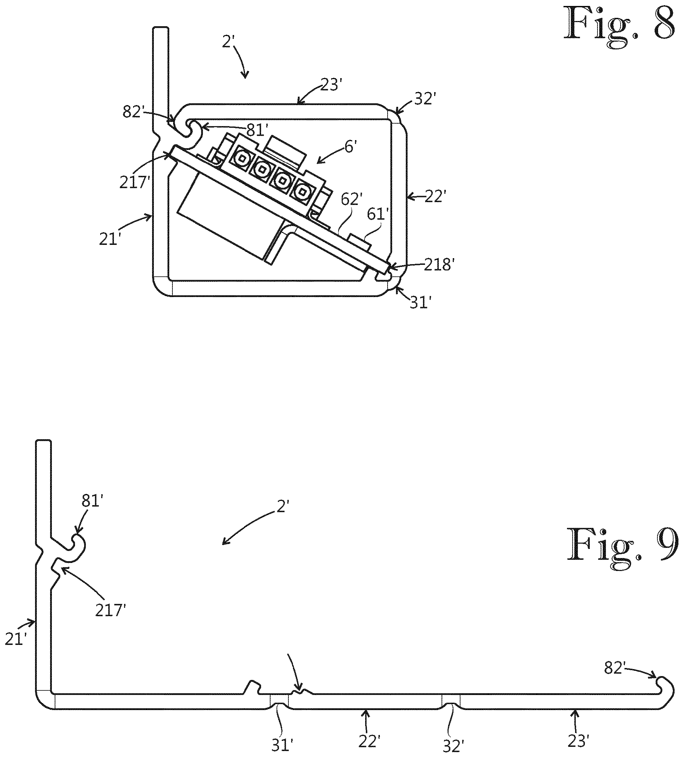

Fig. 8 shows a cross-section of a lighting assembly according to an alternative embodiment, which however, is not included in the scope of protection of the present invention, comprising a housing 2' and a lighting element 6'. The viewing direction of Fig. 8 is parallel to the longitudinal direction. Fig. 9 shows the housing 2' of the lighting assembly of Fig. 8 with housing walls arranged in an installation position relative to each other.

The lighting assembly of Fig. 8 differs from the lighting assembly of Fig. 1 in that the first housing wall 21' is not a substantially planar wall, but has a substantially L-shaped cross-section. Further, the lighting assembly of Fig. 8 does not comprise the holder 4, but the lighting element 6' is directly supported against the internal walls of the housing 2'.

The internal surface of the first housing wall 21' is provided with a first installation recess 217' which is arranged to receive part of the lighting element 6' for keeping the lighting element 6' in place relative to the housing 2'. In addition, a second installation recess 218' is provided at the boundary between the first housing wall 21' and the second housing wall 22' and arranged to receive another part of the lighting element 6' for keeping the lighting element 6' in place relative to the housing 2'. As seen in Fig. 8, a first edge of the circuit card 62' has been received in the first installation recess 217', and a second edge of the circuit card 62' has been received in the second installation recess 218'. The several LEDs 61' of the lighting element 6' are installed on the circuit card 62'.

It is obvious for a person skilled in the art that the basic idea of the invention may be implemented in many different ways. The invention and its embodiments are thus not limited to the above-described examples but may vary within the scope of the claims.

## Claims

1. A lighting assembly, comprising:
a housing (2) manufactured by extrusion from at least one flexible material and comprising a first housing wall (21), a second housing wall (22), a third housing wall (23), a first flexible hinge (31) and a second flexible hinge (32), the first housing wall (21) being pivotably connected to the second housing wall (22) by means of the first flexible hinge (31), and the second housing wall (22) being pivotably connected to the third housing wall (23) by means of the second flexible hinge (32), and both of the first flexible hinge (31) and the second flexible hinge (32) extending in a longitudinal direction, and the first, second, and third housing walls (21, 22, 23) are substantially planar walls; and
a lighting element (6) located inside the housing (2), and arranged to emit light out from the housing (2),
wherein the housing (2) comprises locking means for releasably locking a free edge of the first housing wall (21) to a free edge of the third housing wall (23) to arrange the housing (2) in an operating position, the locking means comprising a first locking member (81) formed in the first housing wall (21), and a second locking member (82) formed in the third housing wall (23) and arranged to cooperate with the first locking member (81), and
the housing (2) is manufactured in one extrusion process, the material of the third housing wall (23) is translucent, and the lighting element (6) is arranged to emit light out from the housing (2) through the third housing wall (23).

2. The lighting assembly according to claim 1, **characterized in that** the lighting assembly comprises a holder (4) located inside the housing (2), the holder being an element manufactured from one sheet blank and comprising a first holder wall (41) and a second holder wall (42), the first holder wall (41) defining a first holder wall plane and the second holder wall (42) defining a second holder wall plane, the first holder wall plane being arranged at a holder wall angle (γ) to the second holder wall plane, and the lighting element (6) being fastened to the holder (4).

3. The lighting assembly according to claim 2, **characterized in that**:
the first housing wall (21) defines a first housing wall plane, and the second housing wall (22) defines a second housing wall plane,
in the operating position of the housing (2) a first operating angle (α₁) of 85° - 95° is provided between the first housing wall plane and the second housing wall plane,
the first flexible hinge (31) is arranged to allow the first housing wall (21) to be pivoted relative to the second housing wall (22) to a first installation position configured for installation of the holder (4) in the housing (2) and for removal of the holder (4) from the housing (2), and
in the first installation position a first installation angle (β₁) which is at least 10° larger than the first operating angle (α₁) is provided between the first housing wall plane and the second housing wall plane.

4. The lighting assembly according to claim 3, **characterized in that** the housing (2) is arranged to be such that if the angle between the first housing wall plane and the second housing wall plane is deflected from the first installation angle (β₁), the angle between the first housing wall plane and the second housing wall plane will tend to return to the first installation angle (β₁).

5. The lighting assembly according to any one of claims 2 - 4, **characterized in that** the housing (2) comprises a retainer projection (215) extending from the free edge of the first housing wall (21) so as to form a retaining recess between the first housing wall (21) and the retainer projection (215), the retaining recess arranged to receive a free edge of the first holder wall (41) for keeping the first holder wall (41) in place relative to the housing (2).

6. The lighting assembly according to any one of claims 3 - 5, **characterized in that**:
the third housing wall (23) defines a third housing wall plane,
in the operating position of the housing (2) a second operating angle (α2) is provided between the second housing wall plane and the third housing wall plane,
the second flexible hinge (32) is arranged to allow the second housing wall (22) to be pivoted relative to the third housing wall (23) to a second installation position configured for installation of the holder (4) in the housing (2) and for removal of the holder (4) from the housing (2), and
in the second installation position a second installation angle (β₂) which is at least 30° larger than the second operating angle (α₂) is provided between the second housing wall plane and the third housing wall plane.

7. The lighting assembly according to claim 6, **characterized in that** the housing (2) is arranged to be such that if the angle between the second housing wall plane and the third housing wall plane is deflected from the second installation angle (β2), the angle between the second housing wall plane and the third housing wall plane will tend to return to the second installation angle (β2).

8. The lighting assembly according to any one of claims 2 - 7, **characterized in that** the holder (4) comprises a third holder wall (43) and a fourth holder wall (44), each located at a respective end of the housing (2) as seen in the longitudinal direction, and the third holder wall (43) and the fourth holder wall (44) are arranged to protect the lighting element (6) by preventing the passage of dirt into the housing (2) from its ends.

9. The lighting assembly according to claim 8, **characterized in that** the third holder wall (43) defines a third holder wall plane, and the fourth holder wall (44) defines a fourth holder wall plane, and both of the third holder wall plane and the fourth holder wall plane are substantially perpendicular to the longitudinal direction.

10. The lighting assembly according to any one of claims 2 - 9, **characterized in that** the holder (4) is manufactured from a metal sheet, such as an aluminium sheet.

11. The lighting assembly according to any one of claims 2 - 10, **characterized in that** an internal surface of the holder (4) comprises a light reflecting area (46), and the lighting element (6) is arranged to emit light out from the housing (2) so that at least part of the light from the lighting element (6) is reflected out from the housing (2) via the light reflecting area (46) of the holder (4) .

12. The lighting assembly according to any one of the preceding claims, **characterized in that** the material thickness of the first flexible hinge (31; 31') is smaller than the material thickness of the first housing wall (21; 21') and the second housing wall (22; 22'), and the material thickness of the second flexible hinge (32; 32') is smaller than the material thickness of the second housing wall (22; 22') and the third housing wall (23; 23').

13. The lighting assembly according to any one of the preceding claims, **characterized in that** the third housing wall (23) is shaped so as to direct light emitted by the lighting element (6) out from the housing (2).

14. The lighting assembly according to any one of the preceding claims, **characterized in that** the lighting element (6) comprises at least one LED (61; 61').

## Patentansprüche

1. Beleuchtungsanordnung, umfassend:
ein Gehäuse (2), das durch Extrusion aus wenigstens einem flexiblen Material hergestellt ist und eine erste Gehäusewand (21), eine zweite Gehäusewand (22), eine dritte Gehäusewand (23), ein erstes flexibles Gelenk (31) und ein zweites flexibles Gelenk (32) umfasst, wobei die erste Gehäusewand (21) mittels des ersten flexiblen Gelenkts (31) schwenkbar mit der zweiten Gehäusewand (22) verbunden ist, und wobei die zweite Gehäusewand (22) mittels des zweiten flexiblen Gelenks (32) schwenkbar mit der dritten Gehäusewand (23) verbunden ist, und wobei sowohl das erste flexible Gelenk (31) als auch das zweite flexible Gelenk (32) sich in einer Längsrichtung erstrecken, und wobei die erste, die zweite und die dritte Gehäusewand (21, 22, 23) im Wesentlichen planare Wände sind; und
ein Beleuchtungselement (6), das innerhalb des Gehäuses (2) lokalisiert und dazu ausgelegt ist, Licht aus dem Gehäuse (2) heraus zu emittieren,
wobei das Gehäuse (2) Verriegelungsmittel zum lösbaren Verriegeln eines freien Rands der ersten Gehäusewand (21) mit einem freien Rand der dritten Gehäusewand (23) umfasst, um das Gehäuse (2) in einer Betriebsoperation anzuordnen, wobei die Verriegelungsmittel ein erstes Verriegelungselement (81) umfassen, das in der ersten Gehäusewand (21) gebildet ist, und ein zweites Verriegelungselement (82), das in der dritten Gehäusewand (23) gebildet und dazu ausgelegt ist, mit dem ersten Verriegelungselement (81) zusammenzuwirken, und
wobei das Gehäuse (2) in einem Extrusionsprozess hergestellt ist, wobei das Material der dritten Gehäusewand (23) transluzent ist, und wobei das Beleuchtungselement (6) dazu ausgelegt ist, Licht aus dem Gehäuse (2) heraus durch die dritte Gehäusewand (23) hindurch zu emittieren.

2. Beleuchtungsanordnung nach Anspruch 1, **dadurch gekennzeichnet, dass** die Beleuchtungsanordnung einen Halter (4) umfasst, der innerhalb des Gehäuses (2) lokalisiert ist, wobei der Halter ein Element ist, das aus einem Schichtrohling hergestellt ist und eine erste Halterwand (41) und eine zweite Halterwand (42) umfasst, wobei die erste Halterwand (41) eine erste Halterwandebene definiert, und die zweite Halterwand (42) eine zweite Halterwandebene definiert, wobei die erste Halterwandebene unter einem Halterwandwinkel (γ) zu der zweiten Halterwandebene angeordnet ist, und wobei das Beleuchtungselement (6) an dem Halter (4) befestigt ist.

3. Beleuchtungsanordnung nach Anspruch 2, **dadurch gekennzeichnet, dass**:
die erste Gehäusewand (21) eine erste Gehäusewandebene definiert, und die zweite Gehäusewand (22) eine zweite Gehäusewandebene definiert,
in der Betriebsposition des Gehäuses (2) ein erster Betriebswinkel (α₁) von 85° bis 95° zwischen der ersten Gehäusewandebene und der zweiten Gehäusewandebene vorgesehen ist,
das erste flexible Gelenk (31) dazu ausgelegt ist, eine Schwenkung der ersten Gehäusewand (21) relativ zu der zweiten Gehäusewand (22) zu einer ersten Installationsposition zu ermöglichen, die für eine Installation des Halters (4) in dem Gehäuse (2) und für eine Entnahme des Halters (4) aus dem Gehäuse (2) konfiguriert ist, und
in der ersten Installationsposition ein erster Installationswinkel (β₁), der um wenigstens 10° größer als der erste Betriebswinkel (α₁) ist, zwischen der ersten Gehäusewandebene und der zweiten Gehäusewandebene vorgesehen ist.

4. Beleuchtungsanordnung nach Anspruch 3, **dadurch gekennzeichnet, dass** das Gehäuse (2) derart ausgelegt ist, dass dann, wenn der Winkel zwischen der ersten Gehäusewandebene und der zweiten Gehäusewandebene von dem ersten Installationswinkel (β₁) abgelenkt wird, der Winkel zwischen der ersten Gehäusewandebene und der zweiten Gehäusewandebene dazu tendieren wird, den ersten Installationswinkel (β₁) zurückzustellen.

5. Beleuchtungsanordnung nach einem der Ansprüche 2 bis 4, **dadurch gekennzeichnet, dass** das Gehäuse (2) einen Haltevorsprung (215) umfasst, der sich von dem freien Rand der ersten Gehäusewand (21) derart erstreckt, dass eine Halteaussparung zwischen der ersten Gehäusewand (21) und dem Haltevorsprung (215) gebildet wird, wobei die Halteaussparung dazu ausgelegt ist, einen freien Rand der ersten Halterwand (41) zu empfangen, um die erste Halterwand (41) relativ zu dem Gehäuse (2) in Position zu halten.

6. Beleuchtungsanordnung nach einem der Ansprüche 3 bis 5, **dadurch gekennzeichnet, dass**:
die dritte Gehäusewand (23) eine dritte Gehäusewandebene definiert,
in der Betriebsposition des Gehäuses (2) ein zweiter Betriebswinkel (α₂) zwischen der zweiten Gehäusewandebene und der dritten Gehäusewandebene vorgesehen ist,
das zweite flexible Gelenk (32) dazu ausgelegt ist, eine Schwenkung der zweiten Gehäusewand (22) relativ zu der dritten Gehäusewand (23) zu einer zweiten Installationsposition zu erlauben, die für eine Installation des Halters (4) in dem Gehäuse (2) und für eine Entnahme des Halters (4) aus dem Gehäuse (2) konfiguriert ist, und
in der zweiten Installationsposition ein zweiter Installationswinkel (β₂), der um wenigstens 30° größer als der zweite Betriebswinkel (α₂) ist, zwischen der zweiten Gehäusewandebene und der dritten Gehäusewandebene vorgesehen ist.

7. Beleuchtungsanordnung nach Anspruch 6, **dadurch gekennzeichnet, dass** das Gehäuse (2) derart ausgelegt ist, dass dann, wenn der Winkel zwischen der zweiten Gehäusewandebene und der dritten Gehäusewandebene von dem zweiten Installationswinkel (β₂) abgelenkt wird, der Winkel zwischen der zweiten Gehäusewandebene und der dritten Gehäusewandebene dazu tendieren wird, den zweiten Installationswinkel (β₂) zurückzustellen.

8. Beleuchtungsanordnung nach einem der Ansprüche 2 bis 7, **dadurch gekennzeichnet, dass** der Halter (4) eine dritte Halterwand (43) und eine vierte Halterwand (44) umfasst, die jeweils bei Betrachtung in der Längsrichtung an einem jeweiligen Ende des Gehäuses (2) lokalisiert sind, und die dritte Halterwand (43) und die vierte Halterwand (44) dazu ausgelegt sind, das Beleuchtungselement (6) zu schützen, indem der Eintritt von Schmutz in das Gehäuse (2) von seinen Enden aus verhindert wird.

9. Beleuchtungsanordnung nach Anspruch 8, **dadurch gekennzeichnet, dass** die dritte Halterwand (43) eine dritte Halterwandebene definiert, und die vierte Halterwand (44) eine vierte Halterwandebene definiert, und sowohl die dritte Halterwandebene als auch die vierte Halterwandebene im Wesentlichen orthogonal zu der Längsrichtung sind.

10. Beleuchtungsanordnung nach einem der Ansprüche 2 bis 9, **dadurch gekennzeichnet, dass** der Halter (4) aus einer Metallschicht wie zum Beispiel einer Aluminiumschicht hergestellt ist.

11. Beleuchtungsanordnung nach einem der Ansprüche 2 bis 10, **dadurch gekennzeichnet, dass** eine Innenoberfläche des Halters (4) ein lichtreflektierendes Gebiet (46) umfasst, und das Beleuchtungselement (6) dazu ausgelegt ist, Licht aus dem Gehäuse (2) heraus derart zu emittieren, dass wenigstens ein Teil des Lichts von dem Beleuchtungselement (6) mittels des lichtreflektierenden Gebiets (46) des Halters (4) aus dem Gehäuse (2) heraus reflektiert wird.

12. Beleuchtungsanordnung nach einem der vorhergehenden Ansprüche, **dadurch gekennzeichnet, dass** die Materialdicke des ersten flexiblen Gelenks (31; 31') kleiner ist als die Materialdicke der ersten Gehäusewand (21; 21') und der zweiten Gehäusewand (22; 22'), und die Materialdicke des zweiten flexiblen Gelenks (32; 32') kleiner ist als die Materialdicke der zweiten Gehäusewand (22; 22') und der dritten Gehäusewand (23; 23').

13. Beleuchtungsanordnung nach einem der vorhergehenden Ansprüche, **dadurch gekennzeichnet, dass** die dritte Gehäusewand (23) derart geformt ist, dass sie Licht, das durch das Beleuchtungselement (6) emittiert wird, aus dem Gehäuse (2) heraus leitet.

14. Beleuchtungsanordnung nach einem der vorhergehenden Ansprüche, **dadurch gekennzeichnet, dass** das Beleuchtungselement (6) wenigstens eine LED (61; 61') umfasst.

## Revendications

1. Ensemble d'éclairage comprenant :
un boîtier (2) fabriqué par extrusion à partir d'au moins un matériau flexible et comprenant une première paroi de boîtier (21), une deuxième paroi de boîtier (22), une troisième paroi de boîtier (23), une première charnière flexible (31) et une seconde charnière flexible (32), la première paroi de boîtier (21) étant raccordée de manière pivotante à la deuxième paroi de boîtier (22) au moyen de la première charnière flexible (31), et la deuxième paroi de boîtier (22) étant raccordée de manière pivotante à la troisième paroi de boîtier (23) au moyen de la seconde charnière flexible (32), et les deux parmi la première charnière flexible (31) et la seconde charnière flexible (32) s'étendant dans une direction longitudinale, et les première, deuxième et troisième parois de boîtier (21, 22, 23) sont des parois sensiblement planaires ; et
un élément d'éclairage (6) positionné à l'intérieur du boîtier (2) et agencé pour émettre la lumière hors du boîtier (2),
dans lequel le boîtier (2) comprend un moyen de verrouillage pour verrouiller de manière amovible un bord libre de la première paroi de boîtier (21) à un bord libre de la troisième paroi de boîtier (23) pour agencer le boîtier (2) dans une position de commande, le moyen de verrouillage comprenant un premier élément de verrouillage (81) formé dans la première paroi de boîtier (21) et un second élément de verrouillage (82) formé dans la troisième paroi de boîtier (23) et agencé pour coopérer avec le premier élément de verrouillage (81), et
le boîtier (2) est fabriqué lors d'un processus d'extrusion, le matériau de la troisième paroi de boîtier (23) est translucide, et l'élément d'éclairage (6) est agencé pour émettre la lumière hors du boîtier (2) en passant par la troisième paroi de boîtier (23).

2. Ensemble d'éclairage selon la revendication 1, **caractérisé en ce que** l'ensemble d'éclairage comprend un support (4) positionné à l'intérieur du boîtier (2), le support étant un élément fabriqué à partir d'une ébauche de feuille et comprenant une première paroi de support (41) et une deuxième paroi de support (42), la première paroi de support (41) définissant un premier plan de paroi de support et la deuxième paroi de support (42) définissant un deuxième plan de paroi de support, le premier plan de paroi de support étant agencé à un angle de paroi de support (γ) par rapport au deuxième plan de paroi de support, et l'élément d'éclairage (6) étant fixé sur le support (4).

3. Ensemble d'éclairage selon la revendication 2, **caractérisé en ce que** :
la première paroi de boîtier (21) définit un premier plan de paroi de boîtier et la deuxième paroi de boîtier (22) définit un deuxième plan de paroi de boîtier,
dans la position de fonctionnement du boîtier (2), un premier angle de fonctionnement (α₁) de 85° - 95° est prévu entre le premier plan de paroi de boîtier et le deuxième plan de paroi de boîtier,
la première charnière flexible (31) est agencée pour permettre à la première paroi de boîtier (21) d'être pivotée par rapport à la deuxième paroi de boîtier (22) dans une première position d'installation configurée pour l'installation du support (4) dans le boîtier (2) et pour le retrait du support (4) du boîtier (2), et
dans la première position d'installation, un premier angle d'installation (β₁) qui est au moins 10° supérieur au premier angle de fonctionnement (α₁) est prévu entre le premier plan de paroi de boîtier et le deuxième plan de paroi de boîtier.

4. Ensemble d'éclairage selon la revendication 3, **caractérisé en ce que** le boîtier (2) est agencé de sorte que si l'angle entre le premier plan de paroi de boîtier et le deuxième plan de paroi de boîtier est dévié du premier angle d'installation (β₁), l'angle entre le premier plan de paroi de boîtier et le deuxième plan de paroi de boîtier a tendance à revenir vers le premier angle d'installation (β₁).

5. Ensemble d'éclairage selon l'une quelconque des revendications 2 à 4, **caractérisé en ce que** le boîtier (2) comprend une saillie de retenue (215) s'étendant à partir du bord libre de la première paroi de boîtier (21) afin de former un évidement de retenue entre la première paroi de boîtier (21) et la saillie de retenue (215), l'évidement de retenue étant agencé pour recevoir un bord libre de la première paroi de support (41) pour maintenir la première paroi de support (41) en place par rapport au boîtier (2).

6. Ensemble d'éclairage selon l'une quelconque des revendications 3 à 5, **caractérisé en ce que** :
la troisième paroi de boîtier (23) définit un troisième plan de paroi de boîtier,
dans la position de fonctionnement du boîtier (2), un second angle de fonctionnement (α2) est prévu entre le deuxième plan de paroi de boîtier et le troisième plan de paroi de boîtier,
la seconde charnière flexible (32) est agencée pour permettre à la deuxième paroi de boîtier (22) d'être pivotée par rapport à la troisième paroi de boîtier (23) par rapport à une seconde position d'installation configurée pour l'installation du support (4) dans le boîtier (2) et pour le retrait du support (4) du boîtier (2), et
dans la seconde position d'installation, un second angle d'installation (β₂) qui est au moins 30° supérieur au second angle de fonctionnement (α₂) est prévu entre le deuxième plan de paroi de boîtier et le troisième plan de paroi de boîtier.

7. Ensemble d'éclairage selon la revendication 6, **caractérisé en ce que** le boîtier (2) est agencé de sorte que si l'angle entre le deuxième plan de paroi de boîtier et le troisième plan de paroi de boîtier est dévié du second angle d'installation (β2), l'angle entre le deuxième plan de paroi de boîtier et le troisième plan de paroi de boîtier a tendance à revenir vers le second angle d'installation (β2).

8. Ensemble d'éclairage selon l'une quelconque des revendications 2 à 7, **caractérisé en ce que** le support (4) comprend une troisième paroi de support (43) et une quatrième paroi de support (44), chacune positionnée au niveau d'une extrémité respective du boîtier (2) comme observé dans la direction longitudinale, et la troisième paroi de support (43) et la quatrième paroi de support (44) sont agencées pour protéger l'élément d'éclairage (6) en empêchant le passage de la saleté dans le boîtier (2) depuis ses extrémités.

9. Ensemble d'éclairage selon la revendication 8, **caractérisé en ce que** la troisième paroi de support (43) définit un troisième plan de paroi de support et la quatrième paroi de support (44) définit un quatrième plan de paroi de support, et à la fois le troisième plan de paroi de support et le quatrième plan de paroi de support sont sensiblement perpendiculaires par rapport à la direction longitudinale.

10. Ensemble d'éclairage selon l'une quelconque des revendications 2 à 9, **caractérisé en ce que** le support (4) est fabriqué à partir d'une feuille de métal, telle qu'une feuille d'aluminium.

11. Ensemble d'éclairage selon l'une quelconque des revendications 2 à 10, **caractérisé en ce qu'**une surface interne du support (4) comprend une zone de réflexion de lumière (46) et l'élément d'éclairage (6) est agencé pour émettre de la lumière hors du boîtier (2) de sorte qu'au moins une partie de la lumière de l'élément d'éclairage (6) est réfléchie à partir du boîtier (2) via la zone de réflexion de lumière (46) du support (4).

12. Ensemble d'éclairage selon l'une quelconque des revendications précédentes, **caractérisé en ce que** l'épaisseur de matériau de la première charnière flexible (31 ; 31') est inférieure à l'épaisseur de matériau de la première paroi de boîtier (21 ; 21') et de la deuxième paroi de boîtier (22 ; 22') et l'épaisseur de matériau de la seconde charnière flexible (32 ; 32') est inférieure à l'épaisseur de matériau de la deuxième paroi de boîtier (22 ; 22') et de la troisième paroi de boîtier (23 ; 23').

13. Ensemble d'éclairage selon l'une quelconque des revendications précédentes, **caractérisé en ce que** la troisième paroi de boîtier (23) est formée afin de diriger la lumière émise par l'élément d'éclairage (6) hors du boîtier (2).

14. Ensemble d'éclairage selon l'une quelconque des revendications précédentes, **caractérisé en ce que** l'élément d'éclairage (6) comprend au moins une diode électroluminescente (61 ; 61').
